# EUROPEAN PATENT APPLICATION

(11) **EP 3 713 384 A1**
(43) Date of publication of application: **23.09.2020**
(21) Application number: 19164059.8
(22) Date of filing: 20.03.2019
(51) Int. Cl.: H05K 13/02, B21F 11/00, B23D 15/00, H01L 21/48, B26D 1/09, B26D 1/00

(54) **DEVICE FOR CUTTING LEADS OF A RADIAL ELECTRONIC COMPONENT**

(71) Applicant: Salcomp Oyj, 24101 Salo (FI)
(72) Inventor: VALJUS, Simo, 08200 Lohja (FI); SAVOLAINEN, Kari, 03220 Tervalampi (FI); KUOSMANEN, Pertti, 08350 Lohja (FI); HÄRKÄLÄ, Pekka, 08350 Lohja (FI); KANTOLA, Juha, 08700 Lohja (FI); MÄKELÄ, Vesa, 08200 Lohja (FI); HEIKKINEN, Henrik, 08100 Lohja (FI); NUMMENPÄÄ, Pekka, 24260 Salo (FI)
(74) Representative: Berggren Oy, Turku

(57) **Abstract**

The present invention provides a device (100) for cutting leads (203, 204) of a radial electronic component (201). The device (100) comprises two cutting blades (101, 102), which are movable with respect to each other. One of the cutting blades (101) comprises two slots (103, 105) having cutting edges (104, 106). The other cutting blade (102) comprises two projecting parts (107, 108) for pressing the leads (203, 204) of the radial electronic component (201) against the cutting edges (104, 106). The projecting parts (107, 108) are provided with grooves (109, 110) for receiving the leads (203, 204) of the radial electronic component (201).

## Description

### TECHNICAL FIELD OF THE INVENTION

The present invention relates to a device for cutting leads of a radial electronic component according to the preamble of the appended independent claim. The invention also relates to a feeder for feeding radial electronic components.

### BACKGROUND OF THE INVENTION

Various devices are known in the prior art for cutting leads of a radial electronic component. An example of such a cutting device comprises two movable cutting blades between which leads of a radial electronic component are positioned. The cutting of the leads is achieved by moving the cutting blades against each other. One of the cutting blades comprises two slots for receiving projecting parts of the other cutting blade. When the cutting blades are moved towards each other, the projecting parts press the leads of the radial electronic component against cutting edges of the slots. As the cutting blades are moved further closer to each other, the projecting parts protrude into the slots, whereby the cutting edges cut the leads.

A problem associated with this known cutting device is that it does not cut properly. After the cutting, the ends of the leads are deformed so that the mounting of the radial electronic component on a circuit board can be difficult. Another problem associated with this known cutting device is that a separate calibration tool must be used to align the leads of the radial electronic component to the correct position with respect to the cutting blades.

### OBJECTIVES OF THE INVENTION

It is the main objective of the present invention to reduce or even eliminate the prior art problems presented above.

It is an objective of the present invention to provide a device for cutting leads of a radial electronic component. In more detail, it is an objective of the invention to provide a cutting device enabling to cut leads of a radial electronic component easily and accurately, and without use of a separate calibration tool to align the leads to the correct position with respect to the cutting device.

In order to realise the above-mentioned objectives, the device according to the invention is characterised by what is presented in the characterising portion of the appended independent claim. Advantageous embodiments of the invention are described in the dependent claims.

### DESCRIPTION OF THE INVENTION

A device for cutting leads of a radial electronic component according to the invention comprises a first cutting blade that comprises a first slot having a first cutting edge and a second slot having a second cutting edge, a second cutting blade that comprises a first projecting part for pressing a first lead of the radial electronic component against the first cutting edge and a second projecting part for pressing a second lead of the radial electronic component against the second cutting edge, and moving means for moving the first cutting blade and the second cutting blade with respect to each other. In the device according to the invention, the first projecting part comprises a first groove for receiving the first lead of the radial electronic component, and the second projecting part comprises a second groove for receiving the second lead of the radial electronic component.

The cutting device according to the invention is used for cutting leads of a radial electronic component. By a radial electronic component is meant an electronic component having leads that project essentially in parallel (side by side) from the same end of a component body, rather than from opposite ends of the component body. The radial electronic component typically comprises two leads, but it can alternatively comprise three, four, five or more than five leads. When mounted on a circuit board, the radial electronic component typically stands up perpendicularly from the circuit board. The parallel leads projecting from a single mounting surface gives the radial electronic component an overall plugin nature, facilitating its use in high-speed automated component mounting devices. Examples of a radial electronic component are a resistor, a capacitor and an inductor.

The cutting device according to the invention comprises two cutting blades, which can be moved with respect to each other. The cutting blades are movable between an open position, wherein the projecting parts are out of the slots, and a closed position, wherein the projecting parts are in the slots. When the cutting blades are in the open position, leads of a radial electronic component can be positioned between the cutting blades. The cutting of the leads is achieved by moving the cutting blades to the closed position. When the cutting blades are moved from the open position to the closed position, first the projecting parts press the leads of the radial electronic component against the cutting edges of the slots, and then, as the cutting blades are moved further closer to each other, the projecting parts protrude into the slots, whereby the cutting edges cut the leads.

The cutting device according to the invention comprises grooves on the projecting parts. The purpose of the grooves is to receive and hold the leads of the radial electronic component during the cutting process. The grooves are preferably formed on the outer ends of the projecting parts and arranged in such a manner that the longitudinal directions of the grooves are essentially perpendicular to the moving direction of the cutting blades. Because of the grooves, a separate calibration tool for aligning the leads of the radial electronic component to the correct position with respect to the cutting blades is not needed.

The cutting blades can be essentially planar and arranged movable in the same plane with each other. The moving means can be configured to linearly move the cutting blades towards and away from each other. The cutting blades are preferably made of a metal alloy, such as stainless steel or tempered tool steel.

The first projecting part is dimensioned to fit into the first slot and the second projecting part is dimensioned to fit into the second slot. Preferably, the projecting part and the corresponding slot have essentially the same cross-sectional shapes so that the projecting part may protrude into the slot in such a manner that the surfaces of the projecting part abut against the corresponding surfaces of the slot. The cross-sectional shape of the projecting part and the corresponding slot is preferably a quadrilateral. Preferably, the cross-sectional shape of the projecting part and the corresponding slot is such that the lead of the radial electronic component can be cut obliquely by the cutting edge of the slot. The cutting edge is one of the leading edges of the slot, i.e. one of the edges that are closest to the projecting part when the cutting blades are in the open position. The length of the projecting parts can be, for example, 2-10 mm. The length of the slots can be, for example, 3-12 mm. The widths of the projecting parts and the slots can be, for example, 1.5-5 mm.

The cutting device according to the invention can be used for cutting leads of a radial electronic component that is a separate component or a component that is attached to a component tape. On the component tape, the radial electronic components are arranged successively. The pitch of component and the lead spacing on the component tape can vary depending on the electronic components used. The radial electronic components are attached to the component tape at their leads. The component tape can be wound on a reel or packed in a box from which the radial electronic components are sequentially delivered to the cutting device to be detached one component at a time from the component tape. The component tape may comprise evenly spaced sprocket holes that can be used to feed the component tape to the cutting device. The pitch of sprocket hole can vary, but it is preferably equal to the pitch of component. The component tape can be, for example, a punched paper tape.

An advantage of the cutting device according to the invention is that leads of a radial electronic component can be cut easily and accurately. After the cutting, the ends of the leads are not deformed, whereby the radial electronic component can be easily mounted on a circuit board. Another advantage of the cutting device according to the invention is that because of the grooves on the projecting parts a separate calibration tool to align leads of a radial electronic component to the correct position with respect to the cutting blades is not needed.

According to an embodiment of the invention the first and second cutting edges are at an angle with respect to the longitudinal directions of the first and second grooves. As a result, the leads of the radial electronic component are cut obliquely. This means that the leads are cut at an angle with respect to the cross direction of the leads. In other words, the leads are cut in such a manner that the cutting surfaces of the leads are inclined. The orientation of the first and second cutting edges with respect to the longitudinal directions of the first and second grooves can be such that the cutting surfaces of the leads are pointing in the same direction, or they are towards or away from each other. That the cutting surfaces are towards each other means that the ends of the leads are bevelled inwardly. That the cutting surfaces are away from each other means that the ends of the leads are bevelled outwardly.

According to an embodiment of the invention the angle between the cutting edge and the longitudinal direction of the groove is between 20 and 70 degrees. This range means that the leads of the radial electronic component are then cut at an angle of 20 to 70 degrees with respective to the longitudinal axis of the lead. This range has been found preferable because it facilitates the mounting of the radial electronic component on a circuit board. The angle between the cutting edge and the longitudinal direction of the groove is preferably between 30 and 60 degrees.

According to an embodiment of the invention the first and second grooves are V-shaped. The V-shaped grooves facilitate the positioning of the leads of the radial electronic component into the grooves. The opening angle of the V-shaped grooves can be, for example, 45-135 degrees or preferably 60-120 degrees.

According to an embodiment of the invention the bottoms of the first and second grooves are rounded. The radius of the groove bottom can be, for example, 0.2-1.0 mm. Preferably, the radius of the groove bottom is essentially the same as the radius of the lead of the radial electronic component. The rounded bottom of the groove improves the cutting result because the lead is evenly supported to the surface of the groove during the cutting process.

According to an embodiment of the invention the longitudinal directions of the first and second grooves are perpendicular to the direction in which the first and second cutting blades are moved with respect to each other. In other words, the longitudinal directions of the first and second grooves are perpendicular to the moving direction of the first and second cutting blades.

According to an embodiment of the invention the first groove is formed on the outer end of the first projecting part and the second groove is formed on the outer end of the second projecting part.

According to an embodiment of the invention the distance between the first and second grooves is in the range of 1.5 to 15 mm. The distance between the first and second grooves is chosen according to the lead spacing of the radial electronic component.

According to an embodiment of the invention the first and second cutting blades are essentially planar, and the moving means is configured to move the first and second cutting blades with respect to each other in the same plane. Preferably, the moving means is configured to linearly move the first and second cutting blades towards and away from each other, between the open position and the closed position. The first and second cutting blades can be rectangular plates. The length of the cutting blade can be, for example, 5-50 mm. The width of the cutting blade can be, for example, 5-25 mm. The thickness of the cutting blade can be, for example, 2-8 mm. Preferably, the slots are provided on one edge of the first cutting blade and the projecting parts are provided on one edge of the second cutting blade.

According to an embodiment of the invention the moving means comprises one or more actuators attached to the first cutting blade and/or the second cutting blade. The actuator can be, for example, a pneumatic cylinder or an electromagnetic cylinder. The one or more actuators are configured to move the first and second cutting blades with respect to each other back and forth in a moving direction. Depending on the application one of the cutting blades can be fixed and the other movable, or both cutting blades can be movable.

The present invention also relates to a feeder for feeding radial electronic components. The feeder according to the invention comprises a device for cutting leads of a radial electronic component according to the invention. In the feeder, the radial electronic components are fed to the cutting device to be detached from a component tape one component at a time.

The feeder according to the invention can be used in an electronic component mounting device for feeding radial electronic components to a pick-up device that mounts the radial electronic components one at a time on a circuit board. The radial electronic component is mounted to a circuit board by inserting the ends of the leads into holes in the circuit board and by pressing the component body towards the circuit board. The ends of the leads that extend through the circuit board are soldered to a circuit pattern on the surface of the circuit board.

The exemplary embodiments of the invention presented in this text are not interpreted to pose limitations to the applicability of the appended claims. The verb "to comprise" is used in this text as an open limitation that does not exclude the existence of also unrecited features. The features recited in the dependent claims are mutually freely combinable unless otherwise explicitly stated.

### BRIEF DESCRIPTION OF THE DRAWINGS

- Figs. 1A-1B: illustrate a cutting device according to an embodiment of the invention,
- figs. 2A-2C: illustrate the cutting of leads of a radial electronic component using the cutting device of figs. 1A-1B, and
- fig. 3: illustrates a feeder according to an embodiment of the invention.

### DETAILED DESCRIPTION OF THE DRAWINGS

The same reference signs are used of the same or like components in different embodiments.

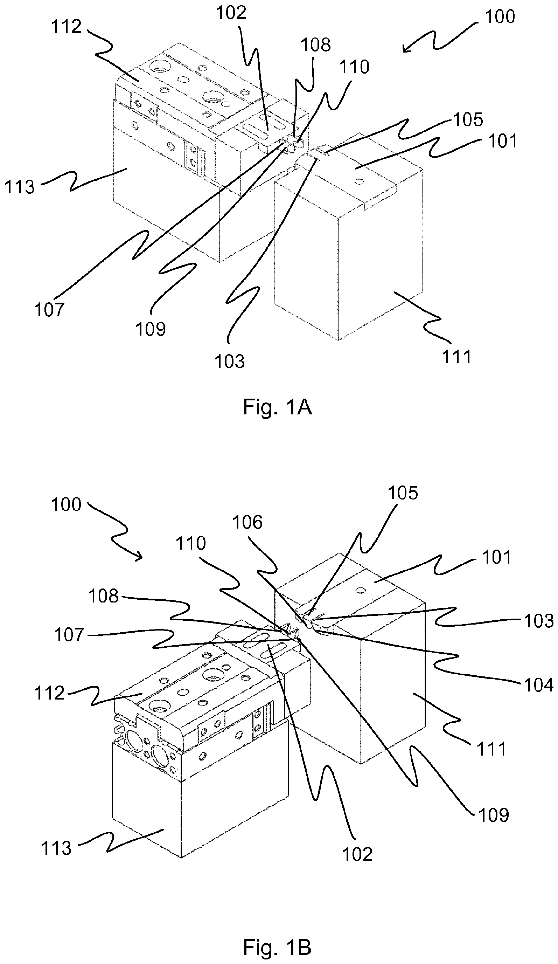

Figs. 1A-1B illustrate a cutting device according to an embodiment of the invention for cutting leads of a radial electronic component. The cutting device 100 comprises a first cutting blade 101 and a second cutting blade 102 between which the leads of the radial electronic component (not shown in figs. 1A-1B) can be positioned. The cutting of the leads is achieved by moving the second cutting blade 102 against the first cutting blade 101.

The first cutting blade 101 comprises a first slot 103 having a first cutting edge 104 and a second slot 105 having a second cutting edge 106. The second cutting blade 102 comprises a first projecting part 107 for pressing the first lead of the radial electronic component against the first cutting edge 104 and a second projecting part 108 for pressing the second lead of the radial electronic component against the second cutting edge 106. The first projecting part 107 and the second projecting part 108 are dimensioned to fit into the first slot 103 and the second slot 105, respectively.

The first projecting part 107 comprises a first groove 109 for receiving the first lead of the radial electronic component, and the second projecting part 108 comprises a second groove 110 for receiving the second lead of the radial electronic component. The grooves 109 and 110 can hold the leads of the radial electronic component during the cutting process. The first groove 109 and the second groove 110 are formed on the outer end of the first projecting part 107 and the second projecting part 108, respectively. The grooves 109 and 110 are arranged in such a manner that their longitudinal directions are essentially perpendicular to the direction in which the second cutting blade 102 is moved with respect to the first cutting blade 101. The grooves 109 and 110 are V-shaped, and their groove bottoms are rounded. The radius of the groove bottoms is essentially the same as the radius of the leads of the radial electronic component.

The cutting edges 104 and 106 are at an angle with respect to the longitudinal directions of the grooves 109 and 110. As a result, the cutting device 100 cuts the leads of the radial electronic component obliquely. The orientation of the cutting edges 104 and 106 with respect to the longitudinal directions of the grooves 109 and 110 is such that the cutting surfaces of the leads are pointing in the same direction.

The first cutting blade 101 is attached to a first fixed base 111. The second cutting blade 102 is attached to a linear actuator 112 that is attached to a second fixed base 113. The linear actuator 112 allows the second cutting blade 102 to be moved linearly towards and away from the first cutting blade 101, and in the same plane with the first cutting blade 101.

The first cutting blade 101 and the second cutting blade 102 are movable between an open position and a closed position. In the open position, the first projecting part 107 is out of the first slot 103 and the second projecting part 108 is out of the second slot 105. In the closed position, the first projecting part 107 is in the first slot 103 and the second projecting part 108 is in the second slot 105. When the cutting blades 101 and 102 are in the open position, the leads of the radial electronic component can be positioned between the cutting blades 101 and 102. The cutting of the leads is achieved by moving the cutting blades 101 and 102 to the closed position. When the cutting blades 101 and 102 are moved from the open position to the closed position, first the projecting parts 107 and 108 press the leads of the radial electronic component against the cutting edges 104 and 106, and then, as the cutting blades 101 and 102 are moved further closer to each other, the projecting parts 107 and 108 protrude into the slots 103 and 105, whereby the cutting edges 104 and 106 cut the leads.

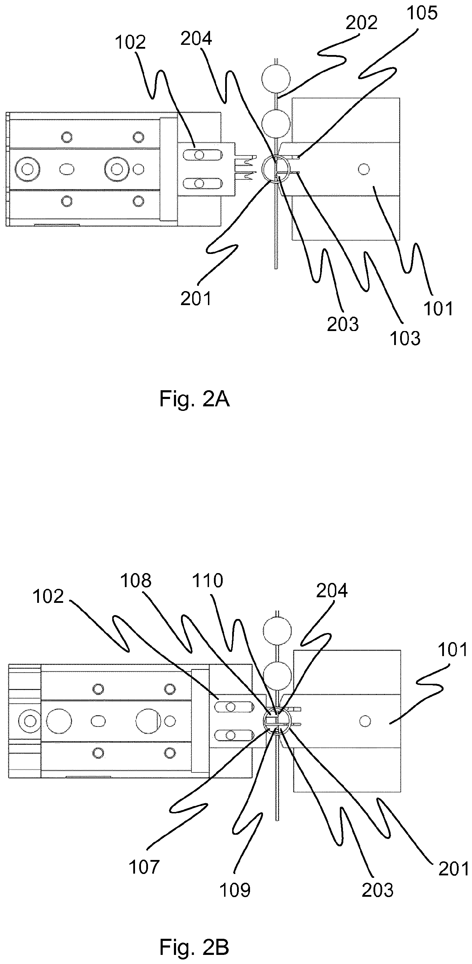

Figs. 2A-2C illustrate the cutting of leads of a radial electronic component using the cutting device of figs. 1A-1B. The component body of the processed radial electronic component 201 is shown transparent in figs. 2A-2C.

In fig. 2A, the first cutting blade 101 and the second cutting blade 102 are in the open position. The radial electronic component 201 that is attached to a component tape 202 is positioned between the first cutting blade 101 and the second cutting blade 102. The radial electronic component 201 is positioned in such a manner that a first lead 203 of the radial electronic component 201 is close to the first slot 103 and the second lead 204 of the radial electronic component 201 is close to the second slot 105 of the first cutting blade 101.

In fig. 2B, the second cutting blade 102 has been moved close to the first cutting blade 101. The first lead 203 and the second lead 204 of the radial electronic component 201 are received into the first groove 109 and the second groove 110, respectively. In fig. 2B, the first projecting part 107 presses the first lead 203 against the first cutting edge 104, and the second projecting part 108 presses the second lead 204 against the second cutting edge 106.

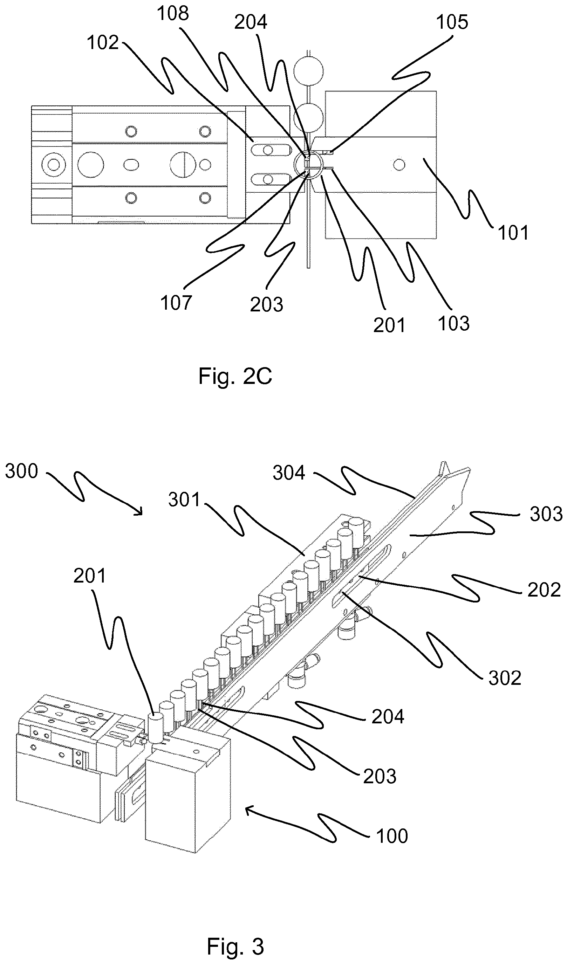

In fig. 2C, the first cutting blade 101 and the second cutting blade 102 have been moved to the closed position. The first projecting part 107 and the second projecting part 108 have protruded into the first slot 103 and the second slot 105, respectively. As a result, the first lead 203 of the radial electronic component 201 has been cut by the first cutting edge 104, and the second lead 204 of the radial electronic component 201 by the second cutting edge 106.

Fig. 3 illustrates a feeder according to an embodiment of the invention for feeding radial electronic components. The radial electronic components 201 are attached at their leads 203 and 204 to a component tape 202 from which the radial electronic components 201 are detached one component at a time using a cutting device 100 that corresponds to the cutting device of figs. 1A-1B. The component tape 202 is fed to the cutting device 100 with an actuator 301 that utilises evenly spaced sprocket holes 302 of the component tape 202 in moving the component tape 202 towards the cutting device 100. The pitch of sprocket hole 302 is equal to the pitch of radial electronic component 201 on the component tape 202. The feeder 300 comprises two guiding plates 303 and 304 between which the component tape 202 is guided to the cutting device 100.

Only advantageous exemplary embodiments of the invention are described in the figures. It is clear to a person skilled in the art that the invention is not restricted only to the examples presented above, but the invention may vary within the limits of the claims presented hereafter. Some possible embodiments of the invention are described in the dependent claims, and they are not to be considered to restrict the scope of protection of the invention as such.

## Claims

1. A device for cutting leads of a radial electronic component, comprising:
- a first cutting blade that comprises a first slot having a first cutting edge and a second slot having a second cutting edge,
- a second cutting blade that comprises a first projecting part for pressing a first lead of the radial electronic component against the first cutting edge and a second projecting part for pressing a second lead of the radial electronic component against the second cutting edge, and
- moving means for moving the first cutting blade and the second cutting blade with respect to each other,
**characterised in that** the first projecting part comprises a first groove for receiving the first lead of the radial electronic component, and the second projecting part comprises a second groove for receiving the second lead of the radial electronic component.

2. The device according to claim 1, **characterised in that** the first and second cutting edges are at an angle with respect to the longitudinal directions of the first and second grooves.

3. The device according to claim 2, **characterised in that** the angle is between 20 and 70 degrees.

4. The device according to any of the preceding claims, **characterised in that** the first and second grooves are V-shaped.

5. The device according to any of the preceding claims, **characterised in that** the bottoms of the first and second grooves are rounded.

6. The device according to any of the preceding claims, **characterised in that** the longitudinal directions of the first and second grooves are perpendicular to the direction in which the first and second cutting blades are moved with respect to each other.

7. The device according to any of the preceding claims, **characterised in that** the first groove is formed on the outer end of the first projecting part and the second groove is formed on the outer end of the second projecting part.

8. The device according to any of the preceding claims, **characterised in that** the distance between the first and second grooves is in the range of 2 to 15 mm.

9. The device according to any of the preceding claims, **characterised in that** the first and second cutting blades are essentially planar, and the moving means is configured to move the first and second cutting blades with respect to each other in the same plane.

10. The device according to any of the preceding claims, **characterised in that** the moving means comprises one or more actuators attached to the first cutting blade and/or the second cutting blade.

11. A feeder for feeding radial electronic components, **characterised in that** the feeder comprises a device for cutting leads of a radial electronic component according to any of the preceding claims.
